# EUROPEAN PATENT APPLICATION

(11) **EP 3 273 447 A1**
(43) Date of publication of application: **24.01.2018**
(21) Application number: 15885601.3
(22) Date of filing: 16.12.2015
(51) Int. Cl.: H01B 5/14, H01B 1/22, H01B 5/00, H01B 13/00, H05K 3/12

(54) **ELECTROCONDUCTIVE FILM AND METHOD FOR MANUFACTURING SAME**

(30) Priority: 16.03.2015 JP 2015051888
(71) Applicant: DOWA Electronics Materials Co., Ltd., Tokyo 101-0021 (JP)
(72) Inventor: FUJITA, Hidefumi, Tokyo 101-0021 (JP); KANEDA, Shuji, Tokyo 101-0021 (JP); ITOH, Daisuke, Tokyo 101-0021 (JP)
(74) Representative: Carstens, Dirk Wilhelm
(86) International application number: PCT/JP2015/085220
(87) International publication number: WO 2016/147509

(57) **Abstract**

[Problem] To provide a copper electroconductive film formed on a paper substrate, the copper electroconductive film being considerably improved in weather resistance and electroconductivity.

[Solution] The problem can be achieved by an electroconductive film formed by pressing a sintered electroconductive film formed by sintering copper particles in a coating film containing copper powder on a paper substrate along with the substrate, the electroconductive film having an area ratio of copper occupying on a cross section of the electroconductive film in parallel to a thickness direction thereof of 82.0% or more. The electroconductive film can be produced by pressing, for example, by roll press to from 90 to 190°C, after light sintering.

## Description

### Technical Field

The present invention relates to a copper electroconductive film formed on a surface of a paper substrate, and a method for producing the same.

### Background Art

As a material for forming an electroconductive circuit on a substrate, an electroconductive coating material (which may also be referred to as an electroconductive paste, an electroconductive ink, or the like) containing an electroconductive filler, such as silver powder and copper powder, has been known, and has been widely subjected in practical use. An electroconductive coating material is generally coated on a substrate by such a manner as printing, and then sintered to form an electroconductive film.

As the electroconductive filler, silver powder is advantageous rather than copper powder in consideration of weather resistance. The metal surface of copper is easily oxidizable, and thus the electroconductive capability of the film may be deteriorated in a relatively early stage depending on the use environment. However, there is a large need of use of an electroconductive coating material using copper powder as a filler, due to the expensiveness of silver.

As an antenna substrate of an RFID tag, there is a need of use of a paper substrate, which is easily broken. Paper generally has a low heat resistant temperature, as different from a flexible substrate, such as a polyimide resin, and ceramics. Accordingly, the formation of an electroconductive circuit with an electroconductive coating material on a surface of a paper substrate necessarily avoids a sintering step where the substrate is exposed to a high temperature. Furthermore, paper easily absorbs moisture, and therefore an electroconductive film formed on a paper substrate is demanded to have higher weather resistance than in the cases where other general substrates are used.

PTL 1 describes an example, in which an antenna pattern is printed on a polyester film having a thickness of 50 µm with an electroconductive paste using silver powder, and then dried at 100°C and pressed at 120°C, thereby forming a silver electroconductive film (paragraphs 0035 to 0037). In this method, the metal particles in the printed conductor are moved to decrease the voids among them by pressing under heating, and thereby the contact area of the metal particles is increased to decrease the resistance of the antenna pattern (paragraph 0034). The method does not use a sintering step, and thus can form an electroconductive film on a substrate that has a low heat resistant temperature. However, the literature does not show an example, in which an electroconductive film is formed by using a copper paste. It is considered that the electroconductive film is inferior in electroconductivity to a sintered thin film since the technique ensures the conductivity through contact of the particles rather than sintering thereof.

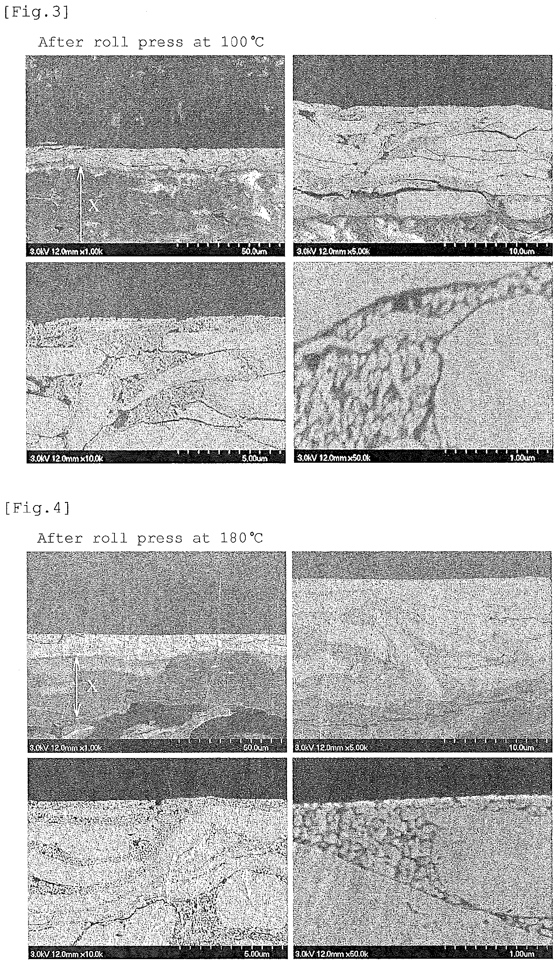

PTL 2 describes that an electroconductive composition containing a thermoplastic resin, a thermosetting resin, a curing agent, and metal particles is coated on a substrate to form a circuit pattern, which is then subjected to a thermal curing step and then a pressing process. There is stated that a pressing roller may be used in the pressing process (paragraph 0040 and Fig. 3). There is stated that through the pressing process, the metal particles are plastically deformed due to the shear stress formed, and the adjacent metal particles are in contact with each other by pressing, so as to form an electroconductive metal bond (paragraph 0035). In the examples thereof, an electroconductive film is formed on a polyimide film, and an example using copper particles is shown in Example 6. There is room for improvement in electroconductivity and weather resistance since the conductive film is considered to have a large amount of voids due to the absence of sintering.

PTL 3 describes a technique, in which a coated film is formed with a copper nanoparticle-containing ink on a flexible substrate, and the copper particles are sintered through irradiation of light. The technique is to sinter metal particles by utilizing a phenomenon, in which metal particles receiving light directly generate heat. In the following description, the process of sintering utilizing the heat generation phenomenon is referred to as "photosintering". A substrate that has a low heat resistant temperature may be used in the photosintering. In this case, however, the heat generation amount of copper particles is necessarily suppressed to the range, in which the temperature of the substrate as the underlayer is not excessively increased. It is difficult to form a copper electroconductive film excellent in electroconductivity and weather resistance through photosintering on a substrate that has a low heat resistant temperature.

### Citation List

### Patent Literatures

PTL 1: JP-A-2000-105809
PTL 2: JP-A-2013-134914
PTL 3: JP-T-2010-528428

### Summary of Invention

### Technical Problem

An object of the invention is to provide a copper electroconductive film formed on a paper substrate, the copper electroconductive film being considerably improved in weather resistance and electroconductivity.

### Solution to Problem

The aforementioned object can be achieved by an electroconductive film formed by pressing a sintered electroconductive film formed by sintering copper particles in a coating film containing copper powder on a paper substrate along with the substrate, the electroconductive film having an area ratio of copper occupying on a cross section of the electroconductive film in parallel to a thickness direction thereof of 82.0% or more, and more preferably 85.0% or more. The pressing measure used may be effectively roll press. In this case, an electroconductive film formed by roll pressing a sintered electroconductive film formed by sintering copper particles in a coating film containing copper powder on a paper substrate along with the substrate, the electroconductive film having an area ratio of copper occupying on a cross section of the electroconductive film in parallel to a thickness direction thereof and to a material running direction in the roll press of 82.0% or more, and more preferably 85.0% or more. The electroconductive film may have an average thickness, for example, of from 5.0 to 20.0 µm. The area ratio of copper occupying on the cross section of the electroconductive film and the average thickness thereof can be obtained in the following manners.

### Measurement Method of Area Ratio of Copper occupying on Cross Section of Electroconductive Film

An operation is performed in such a manner that the cross section of the electroconductive film in parallel to the thickness direction thereof is observed with an SEM (scanning electron microscope) at a magnification of from 5,000 to 10,000, and the area of copper appearing on the cross section (cut surface) of the electroconductive film over the thickness of the film in one or plural observation fields with the fixed position in the perpendicular direction to the thickness direction of the film. The operation is performed to make a total observed area of the cross section of the electroconductive film of 500 µm² or more, for one position or plural positions that are randomly selected in the perpendicular direction to the thickness direction of the film. The total area of copper measured is divided by the total observed area of the cross section of the electroconductive film to provide a value, which is multiplied by 100 to provide a percentage, and the percentage is designated as the area ratio (%) of copper occupying on the cross section of the electroconductive film. For the electroconductive film formed by heat press by a roll press method, the cross section of the electroconductive film in parallel to the thickness direction thereof and to the material running direction in the roll press is observed.

### Measurement Method of Average Thickness

On an image obtained by observing the cross section of the electroconductive film in parallel to the thickness direction thereof with an SEM (scanning electron microscope), the thickness of the electroconductive film is measured in the direction perpendicular to the thickness direction of the film at equally spaced 20 or more positions over a length of 100 µm or more, and the arithmetic average value of the measured values is designated as the average thickness. For the electroconductive film formed by heat press by a roll press method, the cross section of the electroconductive film in parallel to the thickness direction thereof and to the material running direction in the roll press is observed.

As a method for producing the electroconductive film, a production method is provided that contains:
forming a coated film of a coating material containing an organic medium containing a resin, and mixed therewith copper powder, on a paper substrate (coating film forming step);
irradiating the coated film with light having a wavelength component within a range of from 240 to 600 nm, so as to sinter copper particles in the coated film by utilizing heat generation of metallic copper with the light, providing a sintered electroconductive film (light sintering step); and
pressing the sintered electroconductive film heated to from 90 to 190°C with a press along with the paper substrate, so as to increase a copper packing ratio of the sintered electroconductive film (heat pressing step).

The "paper" herein means one that is produced by agglutinating vegetable fibers or other fibers, as defined in JIS P0001:1998, "Terms of paper, paper board, and pulp", No. 4004, and includes synthetic paper produced by using a synthetic polymer substance as a raw material, and one containing a fibrous inorganic material. One having been subjected to a surface treatment with a resin or the like is also included.

In the heat pressing step, a load per unit length in the roll axis direction of the press roll (which may be hereinafter referred to as a "linear pressure") may be, for example, from 90 to 2, 000 N/mm. In the heat pressing step, the copper packing ratio of the sintered electroconductive film is increased, and simultaneously a part of the resin is preferably excluded outside the sintered electroconductive film. In the heat pressing, the copper packing ratio of the sintered electroconductive film is preferably increased to make an area ratio of copper occupying on a cross section of the electroconductive film in parallel to the thickness direction thereof of 82.0% or more. In the case where the heat press is performed by roll press, the copper packing ratio of the sintered electroconductive film is preferably increased to make an area ratio of copper occupying on a cross section of the electroconductive film perpendicular to the roll axis direction (i.e. , a cross section of the electroconductive film in parallel to the thickness direction thereof and to a material running direction in the roll press) of 82.0% or more.

The resin preferably has a smaller deformation resistance at a temperature in a range of from 90 to 190°C than at ordinary temperature. Examples of the case corresponding to the "smaller deformation resistance than at ordinary temperature" include a case where the energy necessary for imparting a certain plastic strain is smaller at ordinary temperature (20±15°C) and a case where the resin that does not show fluidity at ordinary temperature shows fluidity.

The resin preferably contains polyvinylpyrrolidone (PVP). The organic medium preferably contains a glycol solvent.

Examples of the copper powder contained in the coating material include a mixture of fine copper powder A having an average particle diameter of primary particles of from 10 to 100 nm and coarse copper powder B having a 50% cumulative average particle diameter by volume D₅₀ measured with a laser diffraction particle size distribution measuring device of from 0.3 to 20.0 µm at a mass ratio A/B in a range of from 25/75 to 90/10. In this case, the fine copper powder A used is preferably constituted by copper particles coated with an azole compound, such as benzotriazole (BTA). The average particle diameter of primary particles of the fine copper powder A can be obtained from an image obtained by observing the fine copper powder A with an SEM (scanning electron microscope) in the following manner.

### Measurement Method of Average Particle Diameter of Primary Particles of Fine Copper Powder A

An operation is performed in such a manner that the fine copper powder A is observed with an SEM (scanning electron microscope) for an SEM observation field randomly selected, and all the particles each having a recognizable contour showing the overall image of the particle on the SEM image (i.e., all the particles except for particles each having a counter of the particle that cannot be recognized since a part of the particle is obstructed with other particles or protrudes outside the field) are measured for the diameter of the longest portion on the SEM image (i.e., the major axes). The operation is performed for one or plural fields to make a total number of the measured particles of 100 or more, and the arithmetic average value of the major axes of the measured particles is designated as the average particle diameter of primary particles of the fine copper powder A.

### Advantageous Effects of Invention

According to the invention, a copper electroconductive film formed on a paper substrate having a low heat resistant temperature can be considerably improved in weather resistance and electroconductivity. The electroconductive film uses copper powder as an electroconductive filler rather than silver powder, and thus has a lower material cost than a silver electroconductive film. Examples of the preferred applications of the electroconductive film include an antenna circuit for an RFID tag using a paper substrate that is easily broken. In particular, the electroconductive film of the invention is considerably useful in an application, in which suppression of performance deterioration due to moisture is important, such as a merchandise management tag for alcoholic beverages.

### Brief Description of Drawings

Fig. 1 shows the cross sectional SEM micrographs of the electroconductive film after the light sintering.
Fig. 2 shows the cross sectional SEM micrographs of the electroconductive film after the roll press at ordinary temperature.
Fig. 3 shows the cross sectional SEM micrographs of the electroconductive film after the roll press at 100°C.
Fig. 4 shows the cross sectional SEM micrographs of the electroconductive film after the roll press at 180°C.
Fig. 5 shows a graph showing the relationship between the copper packing ratio in the electroconductive film and the communication distance retention ratio.

### Description of Embodiments

The invention provides a copper electroconductive film formed on a paper substrate. The paper substrate has flexibility and is excellent in easy breakability. In contrast, the paper substrate has a lower heat resistant temperature than a flexible substrate having been often used, such as a polyimide resin. The present inventors have confirmed that an electroconductive film can be formed on a paper substrate by a method of causing sintering by utilizing heat generation through light irradiation (light sintering) by using a copper powder-containing coating material (copper paste), and have described the technique in Japanese Patent Application No. 2013-254606. The invention utilizes the light sintering technique.

The copper powder constituting the copper powder-containing coating material necessarily has easily sintering property. Copper nanoparticles having a particle diameter of approximately 100 nm or less have a low sintering temperature and are suitable for light sintering. As a result of various investigations, fine copper powder having an average particle diameter of primary particles of from 10 to 100 nm is preferably contained in the coating material. The fine copper powder of this type is referred to as "fine copper powder A" in the description herein.

The fine copper powder A preferably contains copper particles coated with an azole compound, such as benzotriazole (BTA). As described in Japanese Patent Application No. 2013-254606, the copper nanoparticles having a surface coated with an azole compound are excellent in storage stability and are easily sintered through light irradiation due to the enhancement of the absorbability of light. An azole compound has a conjugated double bond in the molecule thereof, and thus exhibits a function of converting absorbed light in an ultraviolet ray wavelength region of approximately 400 nm or less into heat. For inducing heat generation of metallic copper itself through vibration of electrons of copper atoms, irradiation of light having a wavelength of 600 nm or less is necessarily performed in the invention, and the irradiation of light having a spectrum having a wavelength component in an ultraviolet ray wavelength region provides the heat generation effect of the azole compound coated layer, thereby further facilitating the sintering through light irradiation.

The coating material preferably contains coarse copper powder having an average particle diameter of from 0.3 to 20.0 µm, in addition to the fine copper powder A. The coarse copper powder of this type is referred to as "coarse copper powder B" in the description herein. The average particle diameter of the coarse copper powder B can be expressed by the 50% cumulative average particle diameter by volume D₅₀ measured with a laser diffraction particle size distribution measuring device. The presence of the coarse copper powder B in combination may relax contraction on sintering the copper particles of the fine copper powder A to suppress the sintered structure of copper from being cracked, which is advantageous in enhancement of the electroconductivity. The coarse copper powder B used is more preferably copper powder in a flake form. The copper powder in a flake form may be obtained by mechanically flattening spherical or dendritic copper powder with a ball mill or the like.

The mixing ratio of the fine copper powder A and the coarse copper powder B in terms of mass ratio A/B is preferably in a range of from 25/75 to 90/10. In the range, the crack preventing effect in the light sintering can be easily exhibited, and it is effective for enhancing the packing ratio of copper in the heat roll pressing step described later. The increase of the proportion of the fine copper powder A coated with an azole compound may provide an effect of increasing the amount of the resin that is combusted in the light sintering. It is considerably effective for further improving the weather resistance (i.e., the deterioration resistance of the antenna performance) to facilitate the combustion and removal of the resin in the light sintering and to exclude the residual resin by the heat roll press. In comprehensive consideration of these effects, it is more preferred that the fine copper powder A used is coated with an azole compound, and the mass ratio of the fine copper powder A and the coarse copper powder B A/B is controlled to a range of from 25/75 to 65/35. The content of the copper powder in the coating material (in the case where the fine copper powder A and the coarse copper powder B are mixed, the total content thereof) may be, for example, from 50 to 90% by mass.

The copper powder-containing coating material may be constituted by the copper powder and an organic medium. The organic medium may be constituted mainly by a solvent and a resin, and a dispersant and the like may be added depending on necessity. In the invention, the electroconductive film sintered through light sintering is pressed in a state heated to from 90 to 190°C with a roll press to enhance the packing ratio of copper, as described later. For enhancing the packing ratio of copper in the heat roll pressing step, it is considerably effective that the organic medium present in the voids in the sintered structure of copper is in an easily movable state at the aforementioned temperature range. Accordingly, the organic medium constituting the copper powder-containing coating material preferably has a smaller deformation resistance at a temperature in a range of from 90 to 190°C than at ordinary temperature.

The solvent used is preferably a glycol series solvent, such as ethylene glycol.

The resin used is preferably polyvinylpyrrolidone (PVP) or polyvinylbutyral (PVB). These resins may have a smaller deformation resistance at a temperature in a range of from 90 to 190°C than at ordinary temperature. The amount of the resin mixed in terms of mixing ratio may be effectively from 3 to 10 parts by mass per 100 parts by mass of the copper powder for the case of PVP for example.

For the dispersant, a material having affinity to the surface of the copper particles and the solvent may be selected.

For the solvent, the resin, and the dispersant, various materials have been described in Japanese Patent Application No. 2013-254606. The materials may also be applied to the invention.

### Coated Film Forming Step

The copper powder-containing coating material is coated on the paper substrate. For example, a method of coating to provide a prescribed circuit pattern by screen coating may be employed. After coating, the coating material is heated to such a temperature range that does not deteriorate the paper substrate due to heat and such a temperature range that does not cause oxidation and sintering of the copper powder, so as to evaporate and remove the solvent component as much as possible, thereby forming a coated film to be subjected to light sintering. In the case where the solvent component remains in light sintering, abrasion (roughening of the film) tends to occur due to the evaporation of the solvent component. This preliminary heating treatment is referred to as "preliminary baking". The preliminary baking may be performed, for example, with a vacuum dryer or an IR lamp heater. In the case where a vacuum dryer is used, it is preferred that the coated film is heated in a reduced pressure atmosphere obtained by vacuuming to a temperature in a range of from 50 to 200°C, preferably from 50 to 120°C, and retained for from 10 to 180 minutes. In the case where an IR lamp heater is used, a method of heating in the air atmosphere in an amount of heat of from 140 to 600 J for from 5 to 20 seconds may be employed. The average thickness of the copper powder-containing coated film after the preliminary heating may be, for example, from 5 to 20 µm. The average thickness of the coated film may be obtained in such a manner that the difference in height between the surface of the coated film and the surface of the paper substrate in the vicinity thereof is measured randomly in 100 or more positions using a laser microscope, and the arithmetic average thereof is obtained.

### Light Sintering Step

The copper powder-containing coated film thus formed in the aforementioned manner is irradiated with light, and the copper particles in the coated film are sintered by utilizing heat generation of metallic copper due to the light. For vibrating electrons of copper atoms to cause heat generation of metallic copper, the coated film is necessarily irradiated with light having a wavelength of 600 nm or less, and is effectively irradiated with light having a wavelength component, for example, within a range of from 240 to 600 nm. The light within the wavelength range is also effective for heat generation of the azole compound coated layer as described above. The utilization of the heat generation may enhance the effect of combustion and removal of the resin in the coated film, and is effective for enhancing the weather resistance of the antenna, coupled with the effect of excluding the residual resin by heat press in the subsequent process step. When the copper powder-containing coated film formed on the paper substrate is irradiated with light in the aforementioned wavelength range, the copper particles in and near the surface layer of the coated film within the range that the light reaches generate heat. Sintering quickly occurs in and near the surface layer of the coated film since the copper nanoparticles constituting the fine copper powder A have a low sintering starting temperature, and the sintering is extended to the copper particles of the coarse copper powder B in the vicinity of the copper nanoparticles. The copper particles in the interior that the light does not reach are also sintered through conduction of the heat generated in the surface layer, and a sintered structure of copper is formed in the coated film. The period of time required for the process is approximately one second, and the sintered structure has a small thickness, whereby the temperature of the coated film is quickly lowered when the light irradiation is terminated. Accordingly, the sintering can be completed without burnout of the paper substrate as the underlayer by appropriately controlling the conditions of the light irradiation.

The light source used for the light irradiation may be a xenon flash lamp or the like. Xenon light has a spectrum covering a wavelength range of from 200 to 800 nm and thus is preferred for the light sintering step of the copper powder-containing coated film. In the case where a xenon flash lamp is used, the optimum condition may be set within a range of a pulse period of from 500 to 2, 000 µs and a pulse voltage of from 1, 600 to 3, 800 V. The optimum condition that can avoid damages on the paper substrate as the underlayer and can achieve the sintering to immediately above the substrate can be comprehended in advance by a preliminary experiment corresponding to the composition of the coating material used, the preliminary baking condition, the thickness of the coated film, the heat resistance of the paper substrate, and the like. In the industrial production, the condition for the light sintering may be set based on the data of the preliminary experiment. The copper powder-containing coated film becomes an electroconductive film mainly containing a sintered structure of copper on the paper substrate through the light sintering step. The film is referred to as a "sintered electroconductive film".

### Heat Pressing Step

The resin remains in the interior of the sintered structure of copper constituting the sintered electroconductive film, and voids are also contained therein in a large amount through evaporation of a part of the solvent and resin contained in the coating material. By pressing the sintered electroconductive film to collapse the voids, the electroconductivity is considered to be enhanced by increasing the copper packing ratio. As a general measure for pressing a material in a film form, a roll press method has been known.

In an antenna circuit of an RFID tag, it is considered that the enhancement in electroconductivity acts advantageously on the antenna performance, such as enhancement of the communication distance. However, in the case where a paper substrate having higher moisture absorbability than a plastic substrate is used, it is practically very important to achieve a capability of preventing the antenna performance from being deteriorated in the case where the antenna is allowed to stand in a high temperature and high humidity atmosphere, i.e., to achieve excellent "weather resistance". In the case where the sintered electroconductive film formed on the paper substrate is only enhanced in copper packing ratio by pressing by roll press, such an effect is observed that enhances the electroconductivity (i.e., the antenna performance) in the initial stage, but it is difficult to improve the weather resistance (i.e., the deterioration resistance of the antenna performance) sufficiently.

As a result of the detailed investigations, it has been found that the weather resistance can be imparted by pressing the sintered electroconductive film along with the paper substrate as the underlayer in a state where the sintered electroconductive film to a temperature of from 90 to 190°C. The pressing in a heated state is referred to as "heat press" in the description herein. The reason why the heat press is effective for improving the weather resistance is not sufficiently clarified at this time, but the following factors can be expected.

The deformation resistance of the resin remaining in the sintered electroconductive film is lowered by heating to increase the movability of the resin on pressing, and a part of the remaining resin is excluded outside the sintered electroconductive film. The decrease of the amount of the resin present in the sintered electroconductive film increases the copper packing ratio in the electroconductive film after the heat press, and the electric resistance of the electroconductive film is decreased. The decrease of the electric resistance causes the enhancement of the antenna performance (communication distance). On the other hand, the resin remaining inside has a certain extent of moisture absorbability. The voids inside function as a propagation path of moisture. In the case of the copper electroconductive film having a smaller amount of the resin remaining inside and a smaller volume of the voids, the oxidation of metallic copper due to the moisture is suppressed to provide excellent weather resistance. The electroconductive film having been subjected to the heat press after the light sintering contains a smaller amount of the resin than the electroconductive film having been subjected to press at ordinary temperature without heating, and thus has high weather resistance. It is effective to increase the copper packing ratio (i.e., the area ratio of copper occupying on the cross section of the electroconductive film) to 82.0% or more. In the case where the copper packing ratio is increased to 85.0% or more, in particular, the effect of enhancing the weather resistance becomes more conspicuous (for example, a communication distance retention ratio in the weather resistance evaluation test described later of 85% or more). It is effective to perform the heat press by roll press.

The work roll used in the roll press (i.e. , the roll that is pressed onto the material to be pressed) may have a diameter that can be selected from a range of from 100 to 500 mm, and preferably is from 250 to 450 mm. The press load per unit length in the roll axis direction (linear pressure) is preferably from 90 to 2,000 N/mm. The temperature of the sintered electroconductive film on pressing is preferably from 90 to 190°C. The atmosphere in the heat press may be generally the air atmosphere with no problem, and may be a nitrogen atmosphere in the case where an influence of oxidation of copper appears. In the case where the linear pressure is too large or the temperature is too high, the paper substrate tends to be damaged. In the case where the linear pressure is too small or the temperature is too low, it may be difficult to exclude the resin outside the electroconductive film by utilizing the pressing with the roll, and it is also disadvantageous in enhancement of the packing ratio of copper. Accordingly, the weather resistance may be insufficiently improved. The method of heating may be generally a method of heating the surface of the work roll with a heater inside or outside the roll. In general, the surface temperature of the heated roll can be assumed as the "temperature of the sintered electroconductive film on pressing". The circumferential velocity of the work roll in the roll press (i.e., the running velocity of the material) is preferably from 0.5 to 5 m/min. The average thickness of the electroconductive film after subjecting to the heat roll pressing step may be controlled depending on the purpose, for example, in a range of from 5 to 20 µm.

### Examples

### Production of Copper Powder-containing Coating Material

A solution A was prepared by dissolving 280 g of copper sulfate pentahydrate (produced by JX Nippon Mining & Metals Corporation) and 1 g of benzotriazole (BTA) (produced by Wako Pure Chemical Industries, Ltd.) in 1,330 g of pure water. A solution B was prepared by diluting 20 of a 50% by mass sodium hydroxide aqueous solution (produced by Wako Pure Chemical Industries, Ltd.) with 900 g of pure water. A solution C was prepared by diluting 150 g of a 80% by mass hydrazine monohydrate with 1,300 g of pure water.

The solution A and the solution B were mixed under stirring, the liquid temperature was controlled to 60°C, and then the entire amount of the solution C was added to the mixed liquid under stirring within a period of 30 seconds or less, so as to deposit particles of metallic copper through reduction. The reaction was completed within approximately 5 minutes. The liquid after the reaction (slurry) was subjected to solid-liquid separation, and ethylene glycol (produced by Wako Pure Chemical Industries, Ltd.) was fed to the recovered solid matter, so as to provide a dispersion liquid containing fine copper powder A dispersed in ethylene glycol. The fine copper powder A was constituted by copper particles coated with BTA. The observation of the fine copper powder A with an FE-SEM (field effect scanning electron microscope) (S-4700, produced by Hitachi, Ltd.) revealed that the powder was substantially constituted by spherical particles. The average particle diameter of the fine copper powder A according to the aforementioned "Measurement Method of Average Particle Diameter of Fine Copper Powder A" was approximately 50 nm.

As the coarse copper powder B, copper powder in a flake form (commercially available product) having a 50% cumulative average particle diameter by volume D₅₀ measured with a laser diffraction particle size distribution measuring device of 12 µm was prepared.

With the dispersion liquid of the fine copper powder A, a surfactant using ammonium salt of naphthalenesulfonic acid formaldehyde condensate (MX-2045L, produced by Kao Corporation) as a dispersant, and polyvinylpyrrolidone (PVP) having a weight average molecular weight of 45,000 and a glass transition temperature Tg of approximately 160°C (Pitzcol K-30, produced by Dai-ichi Kogyo Seiyaku Co., Ltd.) as a resin were mixed, and the aforementioned ethylene glycol as a solvent, and the coarse copper powder B were also mixed, so as to provide a copper powder-containing coating material in a paste form. The amounts of the dispersant and the resin mixed therein per 100 parts by mass of the total amount of the copper powder, and the mass ratio of the fine copper powder A and the coarse copper powder B were as shown in Table 1. The amount of the solvent added was controlled to make a content of the copper powder in the copper powder-containing coating material of 73% by mass (which was common to all the examples).

### Formation of Coated Film

As a paper substrate, commercially available coated paper (DF Color M70, produced by Mitsubishi Paper Mills Ltd.) was prepared. As screen printing plates, a screen printing plate A having a mesh number of 250 LPI, a wire diameter of 30 µm, a screen thickness of 60 µm, and an emulsion thickness of 5 µm (ST250-30-60, produced by Sonocom Co., Ltd.), and a screen printing plate B having a mesh number of 200 LPI, a wire diameter of 40 µm, a screen thickness of 80 µm, and an emulsion thickness of 10 µm (ST200-40-80, produced by Sonocom Co. , Ltd.) were prepared. On the paper substrate, an antenna circuit pattern for an RFID was screen-printed with the copper powder-containing coating material through the screen printing plate A (Examples 1 to 9 and Comparative Examples) or the screen printing plate B (Examples 10 to 14), and subjected to vacuum drying at 100°C for 60 minutes with a vacuum dryer as the preliminary baking, so as to provide a copper powder-containing coated film. The antenna circuit pattern had a conductor length of 146 mm, a drawing area of the circuit of approximately 70 mm x 15 mm, and a line width of approximately 0.8 mm.

### Light Sintering

Except for some of the examples, the coated film after the preliminary baking was irradiated with light having a spectrum covering a wavelength range of from 200 to 800 nm with a xenon flash lamp using a pulse irradiation device (Sinteron 2000, produced by Xenon Corporation), so as to form a sintered electroconductive film on the paper substrate. The pulse period was 2, 000 µs, and the pulse voltage was such a condition that provided an electroconductive film with good adhesiveness (without peeling of the film) (described in Table 1).

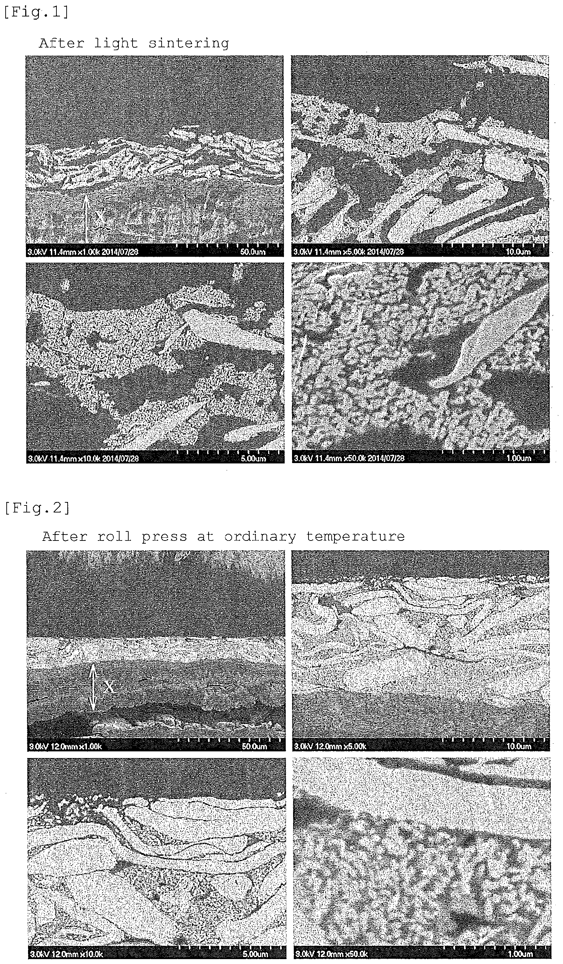

Fig. 1 exemplifies the cross sectional SEM micrographs of the electroconductive film after the light sintering. The micrographs are those of Example 1 in Table 1. The micrographs were obtained by changing the magnification, and the observation magnifications were 1,000, 5,000, 10,000, and 50, 000 in ascending order (which is the same as in Figs. 2 to 4 later). In the figures, the layer shown by the symbol X is the substrate (which is the same as in Figs. 2 to 4 later). A sintered structure of copper particles integrated through sintering is formed.

The resulting sintered electroconductive film was measured for the electric resistance at a line length of 146 mm with a circuit tester (CDM-03D, produced by Custom Corporation).

### Roll Press

Except for some of the examples, the sintered electroconductive film (which was the copper powder-containing coated film after the preliminary baking for the examples without the light irradiation) was pressed along with the paper substrate by using a roll press machine. The work roll was a steel roll having a diameter of 300 mm (Examples 1 to 9 and Comparative Examples) or 400 mm (Examples 10 to 14) . The surface temperature of the roll was controllable with a heater inside the roll. The load per unit length in the roll axis direction (linear pressure) and the temperature on pressing were the conditions shown in Table 1. The circumferential velocity of the work roll was 1 m/min. An electroconductive film having an average thickness of from 5 to 20 µm was thus obtained in this manner.

Figs. 2 to 4 exemplify the cross sectional SEM micrographs of the electroconductive film after the roll press. In all the micrographs below, the longer side direction corresponds to the material running direction in the roll press. Fig. 2 shows the example without heating (Comparative Example 4), Fig. 3 shows the example with heating at 100°C (Example 6), and Fig. 4 shows the example with heating at 180°C (Example 7). With a higher temperature of the roll press, the movement of the resin (PVP) is considered to be active in the sintered structure, and the amount of the coarse voids is decreased.

The electroconductive film after the roll press was measured for the electric resistance in the same manner as above.

The area ratio of copper occupying on the cross section of the electroconductive film in parallel to the thickness direction thereof and to the material running direction in the roll press was obtained from the SEM micrograph observed at a magnification of 5,000 according to the aforementioned "Measurement Method of Area Ratio of Copper occupying on Cross Section of Electroconductive Film", and was designated as the copper packing ratio. The area of copper exposed to the cross section (cut surface) of the electroconductive film was obtained by utilizing an image processing method capable of distinguishing the part having copper exposed to the cross section from the other part. Specifically, the copper part and the other part (including the voids, the resin, and the like) were binarized with image processing software (Scion Image), and the area ratio of the copper part was calculated by the expression (numeric count of copper part/numeric count of total area (copper part and other part)) x 100. The area ratio of copper part can be measured with high precision by setting the threshold value of the binarization process based on the image luminance of the region of the copper part derived only from the coarse copper powder (i.e., the region that clearly has an area ratio of copper of 100%) found in the view field.

### Production of RFID Tag

The electroconductive film formed on the paper substrate after the roll press (which was the sintered electroconductive film after the light sintering for the examples without the roll press) was subjected to a rust preventing treatment or was not subjected to a rust preventing treatment, and was subjected to a test as an antenna.

The rust preventing treatment was performed in the following manner. A rust preventing agent was prepared by diluting N-2-(aminoethyl)-3-aminopropyltrimethoxysilane (molecular weight: 222.4) (KBM-603, produced by Shin-Etsu Chemical Co., Ltd.) with ethanol to a concentration of 40% by mass. The rust preventing agent was coated to cover the portion of the electroconductive film on the paper substrate with a flexographic printing machine (Flexiproof 100, produced by RK Print Coat Instruments, Ltd.) under condition of an anilox volume of 20 cm³/m² (150 lines per inch), a printing speed of 20 m/min, and a printing number of times of 4. The coated amount calculated assuming a transfer ratio of 30% is 0.02 cm³. Thereafter, the electroconductive film was dried in vacuum at 50°C for 1 hour to provide an antenna having been subjected to the rust preventing treatment.

Subsequently, an IC chip was mounted on the antenna, which was laminated with PET films having a thickness of 16 µm with a lamination adhesive, so as to provide an RFID tag.

### Evaluation of Weather Resistance

The RFID tags thus produced above each were measured for the communication distance (theoretical read range forward) in a frequency range of from 800 MHz to 1,100 MHz (according to ISO/IEC 18000-6C) in a radio anechoic chamber (MY1530, produced by Micronics Japan Co., Ltd.) with a communication distance measuring device (Tagformance, produced by Voyantic, Ltd.). Preceding the measurement, the configuration (configuration according to the reference tag attached to Tagformance) was performed.

Subsequently, the RFID tags were subjected to an accelerated weather resistance test in a constant temperature and humidity chamber by retaining under condition of 85°C and 85%RH for 168 hours, and then measured for the communication distance in the same manner as above.

The communication distance before the accelerated weather resistance test is referred to as an "initial communication distance", and the communication distance after the accelerated weather resistance test is referred to as a "communication distance after weather resistance test". Herein, the measured value of the maximum communication distance in the zone of from 800 to 1,100 MHz is employed as the "initial communication distance" and the "communication distance after weather resistance test" of the RFID tag, and the communication distance retention ratio before and after the accelerated weather resistance test is obtained by substituting these values into the following expression (1).

Communication distance retention ratio (%) = (communication distance after weather resistance test (m)/initial communication distance (m)) x 100 (1)

When the communication distance retention ratio is 80% or more, it can be evaluated that practically excellent weather resistance as an RFID tag is achieved.

The results are shown in Table 1.

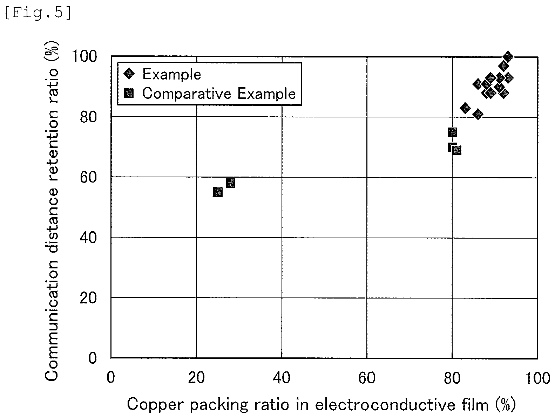

Fig. 5 shows the relationship between the copper packing ratio in the electroconductive film (i.e., the area ratio of copper occupying the cross section of the electroconductive film in parallel to the thickness direction thereof and to the material running direction in the roll press) used as the antenna and the communication distance retention ratio of the RFID tag.

**Table 1**

| Example No. | Composition of coating liquid (copper paste) | | | Light sintering | Roll press | | Rust preventing agent coated | Electric resistance | | Copper packing ratio (%) | Communication distance retention ratio (%) |
|---|---|---|---|---|---|---|---|---|---|---|---|
| | Part by mass per 100 parts by mass of copper powder | | Ratio of fine copper powder A in total amount of copper powder (% by mass) | Voltage (V) | Linear pressure (N/mm) | Temperature (°C) | | After light sintering (Ω) | After roll press (Ω) | | |
| | Resin | Dispersant | | | | | | | | | |
| Example 1 | 6.0 | 2.0 | 30 | 2900 | 400 | 150 | yes | 5.0 | 2.1 | 92 | 88 |
| Example 2 | 6.0 | 2.0 | 40 | 2850 | 400 | 150 | yes | 4.5 | 3.4 | 83 | 83 |
| Example 3 | 6.0 | 2.0 | 50 | 2750 | 400 | 150 | yes | 3.7 | 3.0 | 86 | 91 |
| Example 4 | 6.0 | 2.0 | 60 | 2700 | 400 | 150 | yes | 6.0 | 1.9 | 91 | 90 |
| Example 5 | 4.5 | 2.0 | 40 | 2900 | 400 | 150 | yes | 2.8 | 2.4 | 88 | 88 |
| Example 6 | 6.0 | 2.0 | 30 | 2900 | 400 | 100 | yes | 5.0 | 2.4 | 86 | 81 |
| Example 7 | 6.0 | 2.0 | 30 | 2900 | 400 | 180 | yes | 4.9 | 1.9 | 93 | 93 |
| Example 8 | 6.0 | 2.0 | 30 | 2900 | 200 | 150 | yes | 5.0 | 2.2 | 89 | 88 |
| Example 9 | 6.0 | 2.0 | 30 | 2900 | 100 | 150 | yes | 5.0 | 2.5 | 86 | 81 |
| Example 10 | 4.5 | 3.0 | 60 | 2650 | 400 | 180 | no | 2.7 | 1.8 | 91 | 93 |
| Example 11 | 6.0 | 2.0 | 40 | 2800 | 1818 | 180 | no | 3.1 | 1.7 | 88 | 91 |
| Example 12 | 6.0 | 1.0 | 40 | 2600 | 1818 | 180 | no | 2.7 | 1.5 | 89 | 93 |
| Example 13 | 4.5 | 3.0 | 50 | 2600 | 1818 | 180 | no | 3.1 | 1.5 | 92 | 97 |
| Example 14 | 4.5 | 3.0 | 60 | 2600 | 1818 | 180 | no | 2.8 | 1.7 | 93 | 100 |
| Comparative Example 1 | 6.0 | 2.0 | 30 | 2900 | (not performed) | | yes | 5.1 | - | 25 | 55 |
| Comparative Example 2 | 6.0 | 2.0 | 50 | 2750 | (not performed) | | yes | 3.7 | - | 28 | 58 |
| Comparative Example 3 | 6.0 | 2.0 | 30 | (not performed) | 400 | 180 | yes | (O.L.) | (O.L.) | 79 | - |
| Comparative Example 4 | 6.0 | 2.0 | 30 | 2900 | 400 | (ordinary temperature) | yes | 5.0 | 3.0 | 80 | 70 |
| Comparative Example 5 | 6.0 | 2.0 | 50 | 2750 | 400 | (ordinary temperature) | yes | 3.7 | 3.6 | 81 | 69 |
| Comparative Example 6 | 6.0 | 2.0 | 30 | 2900 | 40 | 150 | yes | 5.0 | 3.3 | 80 | 75 |
| Comparative Example 7 | 6.0 | 2.0 | 30 | 2900 | 400 | 200 | yes | 5.0 | (O.L.) | - | - |

| | | | | | | | | | | | |
|---|---|---|---|---|---|---|---|---|---|---|---|
| O.L.: Over Load | | | | | | | | | | | |

The RFID tags of Examples had a large copper packing ratio in the electroconductive film due to the roll press performed at the prescribed temperature after the light sintering, and were excellent in weather resistance. It was confirmed that excellent weather resistance was obtained even in the case where the coating of the rust preventing agent was omitted.

On the other hand, Comparative Examples 1 and 2 had a small copper packing ratio in the electroconductive film since the roll press after the light sintering was omitted, and were inferior in weather resistance. Comparative Example 3 failed to provide an electroconductive film having electroconductivity capable of sufficiently functioning as an antenna since the light sintering was omitted. Comparative Examples 4 and 5 were inferior in weather resistance to Examples since the roll press was performed at ordinary temperature. Comparative Example 6 was inferior in weather resistance to Examples since the load (linear pressure) of the roll press was small. Comparative Example 7 failed to provide the prescribed antenna since the paper substrate was largely deformed due to the high heating temperature in the roll press.

## Claims

1. An electroconductive film formed by pressing a sintered electroconductive film formed by sintering copper particles in a coating film containing copper powder on a paper substrate along with the substrate, the electroconductive film having an area ratio of copper occupying on a cross section of the electroconductive film in parallel to a thickness direction thereof of 82.0% or more.

2. The electroconductive film according to claim 1, wherein the electroconductive film has an average thickness of from 5.0 to 20.0 µm.

3. A method for producing an electroconductive film comprising:
forming a coated film of a coating material containing an organic medium containing a resin, and mixed therewith copper powder, on a paper substrate (coating film forming step);
irradiating the coated film with light having a wavelength component within a range of from 240 to 600 nm, so as to sinter copper particles in the coated film, providing a sintered electroconductive film (light sintering step); and
pressing the sintered electroconductive film heated to from 90 to 190°C along with the paper substrate, so as to increase a copper packing ratio of the sintered electroconductive film (heat pressing step).

4. The method for producing an electroconductive film according to claim 3, wherein in the heat pressing step, the copper packing ratio of the sintered electroconductive film is increased, and simultaneously a part of the resin is excluded outside the sintered electroconductive film.

5. The method for producing an electroconductive film according to claim 3, wherein in the heat pressing step, a load per unit length in a roll axis direction of from 90 to 2,000 N/mm is applied by roll press.

6. The method for producing an electroconductive film according to claim 5, wherein in the heat pressing step, the copper packing ratio of the sintered electroconductive film is increased to make an area ratio of copper occupying on a cross section of the electroconductive film perpendicular to the roll axis direction of 82.0% or more.

7. The method for producing an electroconductive film according to claim 3, wherein the resin has a smaller deformation resistance at a temperature in a range of from 90 to 190°C than at ordinary temperature.

8. The method for producing an electroconductive film according to claim 3, wherein the coating material contains polyvinylpyrrolidone (PVP) as the resin.

9. The method for producing an electroconductive film according to claim 3, wherein the organic medium contains a glycol series solvent.

10. The method for producing an electroconductive film according to claim 3, wherein the copper powder contained in the coating material contains a mixture of fine copper powder A having an average particle diameter of primary particles of from 10 to 100 nm and coarse copper powder B having a 50% cumulative average particle diameter by volume D₅₀ measured with a laser diffraction particle size distribution measuring device of from 0.3 to 20.0 µm at a mass ratio A/B in a range of from 25/75 to 90/10.

11. The method for producing an electroconductive film according to claim 10, wherein the fine copper powder A is constituted by copper particles coated with an azole compound.

12. The method for producing an electroconductive film according to claim 10, wherein the fine copper powder A is constituted by copper particles coated with benzotriazole (BTA).

13. The method for producing an electroconductive film according to claim 3, wherein the coating material has a content of the copper powder of from 50 to 90% by mass.
